# EUROPEAN PATENT APPLICATION

(11) **EP 4 726 706 A1**
(43) Date of publication of application: **15.04.2026**
(21) Application number: 25202460.9
(22) Date of filing: 16.09.2025
(51) Int. Cl.: G09G 3/3266, H10D 30/67, H10D 86/01, H10D 86/40

(54) **THIN FILM TRANSISTOR SUBSTRATE, MANUFACTURING METHOD THEREOF AND DISPLAY APPARATUS COMPRISING THE SAME**

(30) Priority: 11.10.2024 KR 20240138500
(71) Applicant: LG Display Co., Ltd., Seoul, 07336 (KR)
(72) Inventor: LEE, KwangHeum, 10845 Paju-si, Gyeonggi-do (KR); KIM, Sunggu, 10845 Paju-si, Gyeonggi-do (KR); KIM, Hyunki, 10845 Paju-si, Gyeonggi-do (KR); LEE, Chaewoon, 10845 Paju-si, Gyeonggi-do (KR)
(74) Representative: Bryn-Jacobsen, Caelia

(57) **Abstract**

The present disclosure provides a thin film transistor substrate, a method for manufacturing the thin film transistor substrate and a display apparatus including the thin film transistor substrate. One example of the present disclosure provides a thin film transistor substrate comprising a buffer layer disposed on a base substrate and a plurality of thin film transistors on the buffer layer, wherein the plurality of thin film transistors comprise a plurality of active layers and a gate electrode overlapping at least a portion of each of the plurality of active layers, the buffer layer comprises a plurality of flat areas and a plurality of inclined areas alternately disposed with each other, and the plurality of active layers are spaced apart from each other and disposed in the plurality of flat areas.

## Description

### CROSS-REFERENCE TO RELATED APPLICATIONS

This application claims the benefit of priority of the Korean Patent Application No. 10-2024-0138500 filed on October 11, 2024.

### BACKGROUND

### Field of the Invention

The present disclosure relates to display apparatuses, thin film transistor substrates, display apparatuses comprising the thin film transistor substrate and manufacturing methods.

### Discussion of the Related Art

Since thin film transistors can be manufactured on glass or plastic substrates, they are widely used as switching elements or driving elements in display devices such as liquid crystal display devices or organic light emitting devices.

Thin film transistors can be classified into amorphous silicon thin film transistors in which amorphous silicon is used as the active layer, polycrystalline silicon thin film transistors in which polycrystalline silicon is used as the active layer, and oxide semiconductor thin film transistors in which oxide semiconductor is used as the active layer, based on the material constituting the active layer.

The GIP (Gate in panel) structure, which embeds the gate driver in the form of a thin film transistor in the display panel, can be applied to display devices. When a large number of thin film transistors are disposed in the gate driver to improve the performance of the display device, a method of configuring the thin film transistors by dividing the active layer is used.

In particular, thin film transistors disposed in the output unit of a stage of the gate driver are formed with a large channel width, and when fabricated under the same process conditions, there is a risk that the threshold voltage may shift in the negative direction. Therefore, in order to improve such a problem, a method of configuring the thin film transistors by dividing the active layer has been adopted.

Recently, for dividing active layers, research has been conducted to reduce the gap between active layers in order to reduce the area of the bezel area corresponding to the outer part of the display panel.

### SUMMARY

One example of the present disclosure is to provide a thin film transistor substrate in which a layer having a step is disposed below an active layer to separate the active layers from each other. This step is achieved by having a plurality of active layers which are spaced apart from each other by a plurality of inclined areas and disposed in the plurality of flat areas. The thin film transistor substrate described herein is suitable for use in a display apparatus. A display apparatus may comprise the thin film transistor substrate described herein.

One example of the present disclosure is to provide a thin film transistor substrate in which the gap between active layers is minimized.

Another example of the present disclosure is to provide a display device with a reduced bezel area.

One example of the present disclosure for achieving the above-described technical advantage provides a thin film transistor substrate comprising a buffer layer disposed on a base substrate and a plurality of thin film transistors on the buffer layer, wherein the plurality of thin film transistors comprise a plurality of active layers and a gate electrode overlapping at least a portion of each of the plurality of active layers, the buffer layer comprises a flat area and an inclined area alternately disposed with each other, and the plurality of active layers are spaced apart from each other and disposed in the flat area.

The plurality of active layers comprise an oxide semiconductor material and may have a crystalline structure.

The plurality of active layers are disposed to be spaced apart from each other in a first direction, the flat area and the inclined area are disposed to extend along a second direction perpendicular to the first direction, and the flat area and the inclined area can be disposed to be parallel along the first direction.

The buffer layer comprises a first flat surface and a second flat surface disposed in the flat area, and an inclined surface disposed in the inclined area, and the plurality of active layers may not be disposed on the inclined surface.

The first flat surface, the inclined surface, and the second flat surface extend along the first direction, the inclined surface is disposed between the first flat surface and the second flat surface, and the shortest distance between the first flat surface and the base substrate can be shorter than the shortest distance between the second flat surface and the base substrate.

Preferably, the inclined surface can have a taper angle of 45 to 90°. In one or more examples, the taper angle may be between 45 to 50°. In one or more examples, the taper angle may be between 50 to 55°. In one or more examples, the taper angle may be between 45 to 65°. In one or more example, the taper angle may be between 65 to 75°. In one or more example, the taper angle may be between 75 to 90°.

The plurality of active layers may have a spacing of 0.5 µm or less in a plane.

The plurality of active layers comprise a lower active layer disposed on the first flat surface; and an upper active layer disposed on the second flat surface, wherein the lower active layer and the upper active layer are alternately disposed along the first direction, and the shortest distance between the upper surface of the lower active layer and the base substrate may be shorter than the shortest distance between the upper surface of the upper active layer and the base substrate.

The gate electrode may extend in a first direction across the plurality of active layers and be disposed on the flat area and the inclined area.

The thin film transistor substrate further comprises a gate insulating film disposed on the buffer layer, wherein the plurality of active layers are disposed between the buffer layer and the gate insulating film in the flat area, and the gate insulating film can be in contact with the buffer layer in the inclined area.

The buffer layer may comprise a trench, the inclined surfaces may be disposed on both sides of the trench, and a first flat surface may be disposed between the inclined surfaces.

Another example of the present disclosure can provide a method for manufacturing a thin film transistor substrate, including the steps of forming a buffer layer on a base substrate; forming a photoresist pattern on the buffer layer; etching the buffer layer using the photoresist pattern as a mask to form flat areas and inclined areas that are alternately disposed; forming an active material layer on the buffer layer; annealing the active material layer; and removing a portion of the active material layer disposed in the inclined area by wet etching.

The active material layer disposed on the flat area can be crystallized by the annealing treatment step.

The thickness of the active material layer disposed in the inclined area is 10% to 60% compared to the thickness of the active material layer disposed in the flat area, and the thickness of the active material layer can be measured in a direction perpendicular to the surface of the buffer layer.

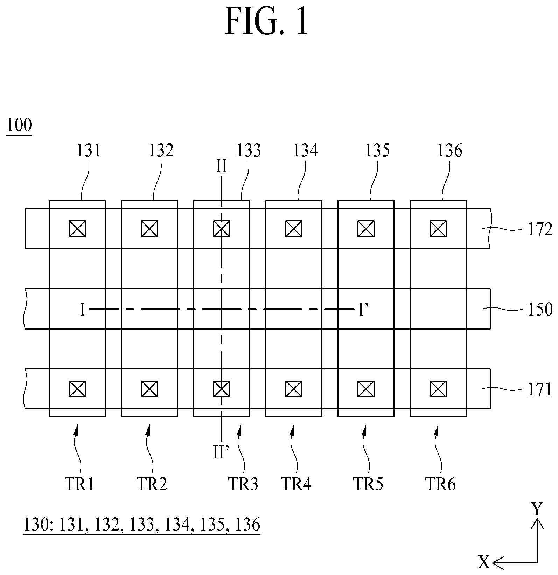

The width of a single channel may be approximately 10 to 20 micrometers based on a direction X. The thin-film transistor (TFT) substrate shown in FIG. 1 may have a width of approximately 60 to 120+(0.5x5 µm) micrometers. The spacing between the active layers may be 0.5 µm or less. The length of a single channel may be approximately 5 to 10 micrometers based on a direction Y. In one or more examples, The length of a single active layer may be approximately 18 to 23 micrometers based on a direction Y. The thin-film transistor (TFT) substrate shown in FIG. 1 may have the length of approximately 18 to 23 micrometers.

Another example of the present disclosure can provide a display device including a thin film transistor substrate.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view of a thin film transistor substrate according to one example of the present disclosure.
FIG. 2 is a cross-sectional view taken along line I-I' of FIG. 1.
FIG. 3 is a cross-sectional view taken along line II-II' of FIG. 1.
FIG. 4 is an enlarged view showing area A of FIG. 2 in detail.
FIG. 5 is an enlarged view of a thin film transistor substrate according to another example of the present disclosure.
FIGS. 6A to 6H are process diagrams showing a manufacturing process of a thin film transistor substrate according to another example of the present disclosure.
FIG. 7 is a schematic diagram of a display device according to another example of the present disclosure.
FIG. 8 is a schematic diagram of a display panel according to one example of the present disclosure.
FIG. 9 is a block diagram schematically illustrating a stage according to one example of the present disclosure.
FIG. 10 is a cross-sectional view taken along line III-III' of FIG. 8.
FIG. 11 is an enlarged view of area B of FIG. 10.

### DETAILED DESCRIPTION OF THE DISCLOSURE

Advantages and features of the present disclosure and implementation methods thereof will be clarified through following examples described with reference to the accompanying drawings. The present disclosure may, however, be embodied in different forms and should not be construed as limited to the examples set forth herein. Rather, these examples are provided so that this disclosure will be thorough and complete and will fully convey the scope of the present disclosure to those skilled in the art. Further, the present disclosure is only defined by scopes of claims.

A shape, a size, a ratio, an angle and a number disclosed in the drawings for describing examples of the present disclosure are merely an example and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted.

In a case where 'comprise', 'have' and 'comprise' described in the present disclosure are used, another portion may be added unless 'only~' is used. The terms of a singular form may comprise plural forms unless referred to the contrary.

In construing an element, the element is construed as including an error band although there is no explicit description.

In describing a position relationship, for example, when the position relationship is described as 'upon~', 'above~', 'below~' and 'next to~', one or more portions may be disposed between two other portions unless 'just' or 'direct' is used.

Spatially relative terms such as "below", "beneath", "lower", "above", and "upper" may be used herein to easily describe a relationship of one element or elements to another element or elements as illustrated in the drawings. It will be understood that these terms are intended to encompass different orientations of the device in addition to the orientation depicted in the drawings. For example, if the device illustrated in the figure is reversed, the device described to be arranged "below", or "beneath" another device may be arranged "above" another device. Therefore, an exemplary term "below or beneath" may comprise "below or beneath" and "above" orientations. Likewise, an exemplary term "above" or "on" may comprise "above" and "below or beneath" orientations.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may comprise all combinations of two or more elements selected from the first, second and third elements as well as each element of the first, second and third elements.

Features of various examples of the present disclosure may be partially or overall coupled to or combined with each other and may be variously inter-operated with each other and driven technically as those skilled in the art can sufficiently understand. The examples of the present disclosure may be carried out independently from each other or may be carried out together in a co-dependent relationship.

In the addition of reference numerals to the components of each drawing describing examples of the present disclosure, the same components can have the same sign as can be displayed on the other drawings.

In the examples of the present disclosure, a source electrode and a drain electrode are distinguished for convenience of description, and the source electrode and the drain electrode may be interchanged. The source electrode may be the drain electrode and vice versa. In addition, the source electrode of any one example may be a drain electrode in another example, and the drain electrode of any one example may be a source electrode in another example.

In some examples of the present disclosure, for convenience of description, a source area is distinguished from a source electrode, and a drain area is distinguished from a drain electrode, but examples of the present disclosure are not limited thereto. The source area may be the source electrode, and the drain area may be the drain electrode. In addition, the source area may be the drain electrode, and the drain area may be the source electrode.

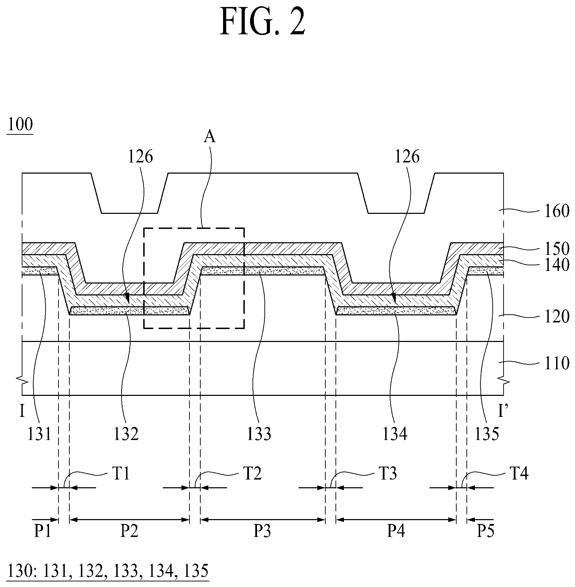

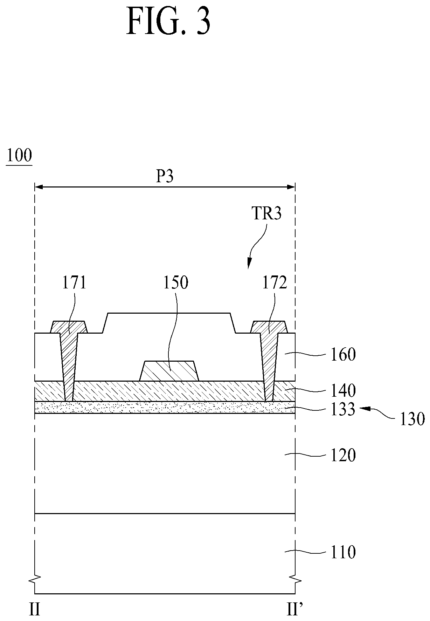

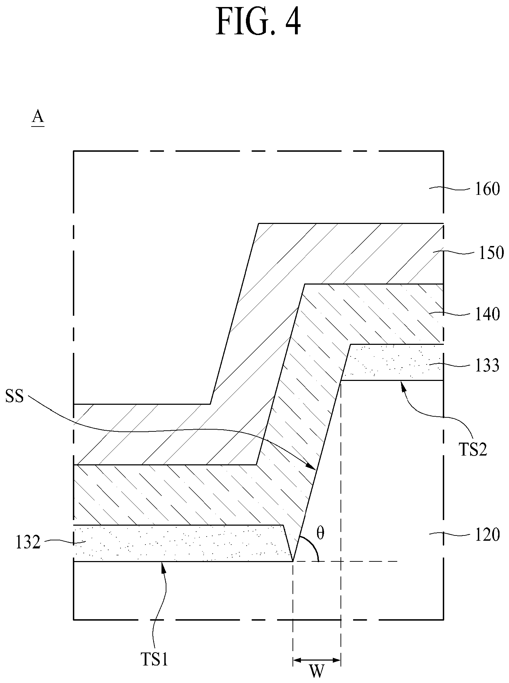

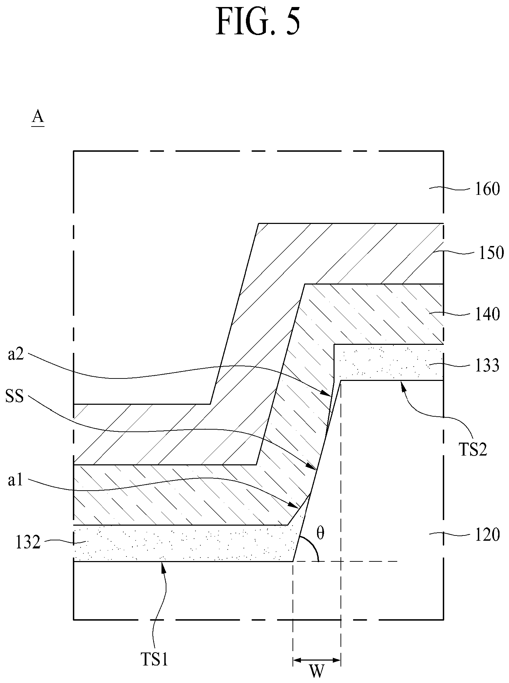

FIG. 1 is a plan view of a thin film transistor substrate 100 according to one example of the present disclosure. FIG. 2 is a cross-sectional view taken along line I-I' of FIG. 1. FIG. 3 is a cross-sectional view taken along line II-II' of FIG. 1. FIG. 4 is an enlarged view showing area A of FIG. 2 in detail. FIG. 5 is an enlarged view of a thin film transistor substrate according to another example of the present disclosure.

A thin film transistor substrate 100 according to one example of the present disclosure comprises a plurality of thin film transistors TR1, TR2, TR3, TR4, TR5, TR6.

Although FIG. 1 illustrates a thin film transistor substrate 100 including six thin film transistors TR1, TR2, TR3, TR4, TR5, TR6, the examples of the present disclosure are not limited thereto, and may comprise less than six thin film transistors or may comprise seven or more thin film transistors.

The plurality of thin film transistors TR1, TR2, TR3, TR4, TR5, and TR6 according to one example of the present disclosure are not individually driven, but the thin film transistor substrate 100 operates as a single transistor. That is, the plurality of thin film transistors TR1, TR2, TR3, TR4, TR5, and TR6 are driven simultaneously. Therefore, the thin film transistor substrate 100 according to one example of the present disclosure may be referred to as a single thin film transistor.

According to one example of the present disclosure, a buffer layer 120 may be disposed on a base substrate 110, and a plurality of thin film transistors TR1, TR2, TR3, TR4, TR5, TR6 may be disposed on the buffer layer 120.

According to one example of the present disclosure, a plurality of thin film transistors TR1, TR2, TR3, TR4, TR5, TR6 comprise a plurality of active layers 130 and gate electrodes 150.

The components of the base substrate 110, buffer layer 120, and multiple thin film transistors TR1, TR2, TR3, TR4, TR5, TR6 are described in detail below.

Glass or plastic may be used as the base substrate 110. A transparent plastic having flexible properties, such as polyimide, may be used as the plastic. For example, referring to FIG. 3, a third thin film transistor TR3 may be disposed on the base substrate 110.

A light-blocking layer (not shown) may be disposed on the base substrate 110. The light-blocking layer (not shown) blocks light incident from the base substrate 110 and protects the plurality of active layers 130. If another structure serves as a light blocking structure, the light-blocking layer (not shown) may be omitted.

According to one example of the present disclosure, a buffer layer 120 may be disposed on a base substrate 110.

The buffer layer 120 has insulating properties and protects a plurality of active layers 130. The buffer layer 120 may comprise at least one of insulating silicon oxide (SiOx), silicon nitride (SiNx), and metal oxide.

In FIGS. 2 and 3, the buffer layer 120 is illustrated as a single layer, but the examples of the present disclosure are not limited thereto. The buffer layer 120 may comprise a plurality of layers. In addition, another layer may be disposed between the base substrate 110 and the buffer layer 120, and another layer may be disposed between the buffer layer 120 and a plurality of active layers 130.

According to one example of the present disclosure, the buffer layer 120 comprises flat areas P1, P2, P3, P4, P5 and inclined areas T1, T2, T3, T4 that are alternately disposed.

The flat areas P1, P2, P3, P4, P5 may comprise a first flat area P1, a second flat area P2, a third flat area P3, a fourth flat area P4, and a fifth flat area P5, respectively. The inclined areas T1, T2, T3, T4 may comprise a first inclined area T1, a second inclined area T2, a third inclined area T3, and a fourth inclined area T4, respectively.

FIG. 2 illustrates a buffer layer 120 comprising flat areas P1, P2, P3, P4, P5 and inclined areas T1, T2, T3, T4 that are alternately disposed. The first inclined area T1 may be between the first flat area P1 and the second flat area P2. The second inclined area T2 may be between the second flat area P2 and the third flat area P3. The third inclined area T3 may be between the third flat area P3 and the fourth flat area P4. The fourth inclined area T4 may be between the fourth flat area P4 and the fifth flat area P5. Although FIG. 2 illustrates five flat areas P1, P2, P3, P4, P5, the examples of the present disclosure are not limited thereto, and may have six or more, or may have less than five. In addition, although FIG. 2 illustrates four inclined areas T1, T2, T3, T4, the examples of the present disclosure are not limited thereto, and may have five or more, or may have less than four.

According to one example of the present disclosure, a plurality of active layers 130 are disposed on a buffer layer 120. For example, the plurality of active layers 130 may be disposed in flat areas P1, P2, P3, P4 while being spaced apart from each other. For example, at least one active layer 130, 131, 132, 133, 134, 135 may be present in each flat area P1, P2, P3, P4 while being spaced apart from each other by inclined areas T1, T2, T3, T4.

According to one example of the present disclosure, the plurality of active layers 130 comprise an oxide semiconductor material.

The oxide semiconductor material may comprise, for example, at least one of an IZO (InZnO)-based oxide semiconductor material, an IGO (InGaO)-based oxide semiconductor material, an ITO (InSnO)-based oxide semiconductor material, an IGZO (InGaZnO)-based oxide semiconductor material, an IGZTO (InGaZnSnO)-based oxide semiconductor material, a GZTO (GaZnSnO)-based oxide semiconductor material, a GZO (GaZnO)-based oxide semiconductor material, an ITZO (InSnZnO)-based oxide semiconductor material, and a FIZO (FeInZnO)-based oxide semiconductor material. However, the examples of the present disclosure are not limited thereto, and the active layer 130 may be made of other oxide semiconductor materials known in the art.

The plurality of active layers 130 may comprise a first active layer 131, a second active layer 132, a third active layer 133, a fourth active layer 134, a fifth active layer 135, and a sixth active layer 136. However, the examples of the present disclosure are not limited thereto, and may comprise less than six active layers, or may comprise seven or more active layers.

For example, FIG. 2 illustrates a state in which, among a plurality of active layers 130, a first active layer 131 is disposed in a first flat area P1, a second active layer 132 is disposed in a second flat area P2, a third active layer 133 is disposed in a third flat area P3, a fourth active layer 134 is disposed in a fourth flat area P4, and a fifth active layer 135 is disposed in a fifth flat area P5. In this example, the first active layer 131, the second active layer 132, the third active layer 133, the fourth active layer 134, and the fifth active layer 135 are disposed spaced apart from each other.

According to one example of the present disclosure, when the direction connecting the source electrode 171 and the drain electrode 172 with the shortest distance is referred to as the second direction Y, the direction perpendicular to the second direction Y may be referred to as the first direction X.

According to one example of the present disclosure, a plurality of active layers 130 are disposed to be spaced apart from each other in a parallel along a first direction X. According to one example of the present disclosure, a plurality of active layers 130 are disposed to extend along a second direction Y.

For example, FIG. 1 illustrates a first active layer 131, a second active layer 132, a third active layer 133, a fourth active layer 134, a fifth active layer 135, and a sixth active layer 136 being disposed in a parallel spaced apart from each other along the first direction X. For example, FIG. 1 illustrates a first active layer 131, a second active layer 132, a third active layer 133, a fourth active layer 134, a fifth active layer 135, and a sixth active layer 136 being disposed to extend along the second direction Y.

According to one example of the present disclosure, the flat areas P1, P2, P3, P4, P5 and the inclined areas T1, T2, T3, T4 of the buffer layer 120 are respectively disposed to extend along the second direction Y.

For example, referring to FIGS. 1 and 3, the third flat area P3 of the buffer layer can extend along the second direction Y.

According to one example of the present disclosure, the flat areas P1, P2, P3, P4, P5 and the inclined areas T1, T2, T3, T4 of the buffer layer 120 can be disposed parallel along the first direction X.

For example, referring to FIGS. 1 and 2, the flat areas P1, P2, P3, P4, P5 and the inclined areas T1, T2, T3, T4 of the buffer layer 120 can be disposed in parallel along the first direction X. In addition, any one of the flat areas P1, P2, P3, P4, P5 can be disposed between two other inclined areas T1, T2, T3, T4. In addition, any one of the inclined areas T1, T2, T3, T4 can be disposed between two other flat areas P1, P2, P3, P4, P5.

According to one example of the present disclosure, the buffer layer 120 may comprise a first flat surface TS1 and a second flat surface TS2 disposed in flat areas P1, P2, P3, P4, P5. The buffer layer 120 may comprise an inclined surface SS disposed in each inclined area T1, T2, T3, T4.

FIG. 4 illustrates a buffer layer 120 including a first flat surface TS1, a second flat surface TS2, and an inclined surface SS. For example, the first flat surface TS1 may be the surface of the second flat area P2 and the fourth flat area P4, the second flat surface TS2 may be the surface of the first flat area P1, the third flat area P3 and the fifth flat area P5, and the inclined surface SS may be the surface of the inclined areas T1, T2, T3, T4.

According to one example of the present disclosure, a flat surface may mean a surface parallel to the upper surface of the base substrate 110 in the buffer layer 120. An inclined surface may mean a surface having a certain angle with respect to the upper surface of the base substrate 110 in the buffer layer 120.

According to one example of the present disclosure, the shortest distance between the first flat surface TS1 and the base substrate 110 may be shorter than the shortest distance between the second flat surface TS2 and the base substrate 110. For example, the first flat surface TS1 is disposed closer to the base substrate 110 compared to the second flat surface TS2.

According to one example of the present disclosure, a second active layer 132 is disposed on the first flat surface TS1 and a third active layer 133 is disposed on the second flat surface TS2. The second active layer 132 and the third active layer 133 are not disposed on the inclined surface SS as shown in FIG. 4.

According to one example of the present disclosure, a plurality of active layers 130 may be disposed on the first flat surface TS1 and the second flat surface TS2. Each active layer 132, 133 may comprise a region a1, a2. The regions a1, a2 are configured to remain at the ends of the inclined surfaces SS as shown in FIG. 5. The regions a1, a2 are configured to be positioned at the ends of the inclined surfaces SS. The thickness of the regions a1, a2 remaining at the ends of the inclined surfaces SS may be smaller than the thicknesses of the plurality of active layers 132, 133 disposed on the first flat surface TS1 and the second flat surface TS2.

Since the area a1, a2 remaining at the end of the inclined surface SS is disposed along the inclined surface SS, the area a1, a2 remaining at the end of the inclined surface SS can be disposed to extend along the second direction Y. The area a1, a2 remaining at the end of the inclined surface SS can comprise the area a1 remaining at the lower end of the inclined surface SS and the area a2 remaining at the upper end of the inclined surface SS.

According to one example of the present disclosure, the first flat surface TS1, the inclined surface SS and the second flat surface TS2 extend along the first direction X.

FIGs. 2 and 4 illustrate a first flat surface TS1, an inclined surface SS, and a second flat surface TS2 extending sequentially along the first direction X. That is, along the first direction X, the first flat surface TS1 extends to the inclined surface SS, and the inclined surface SS extends to the second flat surface TS2.

According to one example of the present disclosure, the inclined surface SS is disposed between the first flat surface TS1 and the second flat surface TS2. FIG. 4 illustrates a state in which the first flat surface TS1 is disposed on one side of the inclined surface SS and the second flat surface TS2 is disposed on the other side of the inclined surface SS.

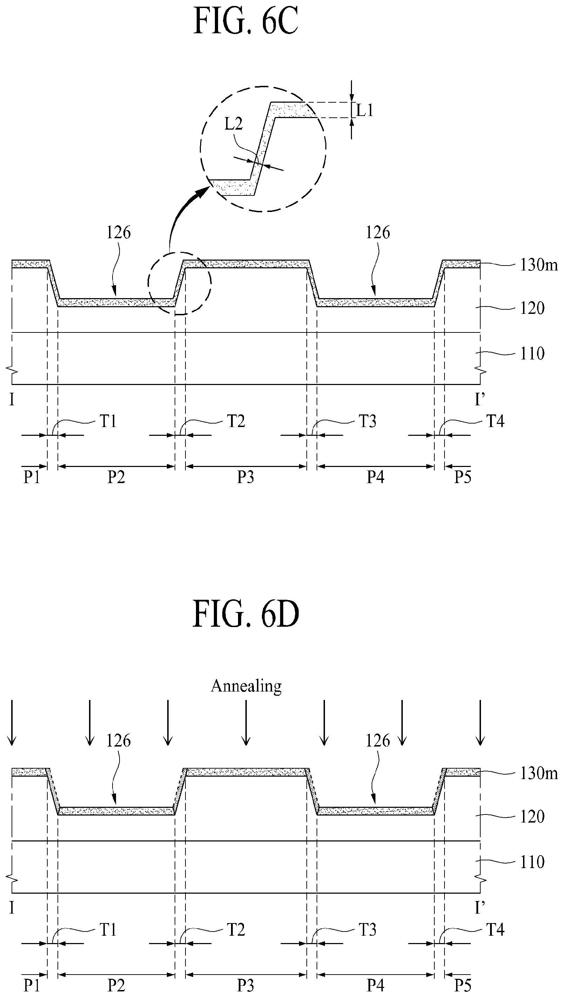

According to one example of the present disclosure, when forming an active material layer 130m in the flat areas P1, P2, P3, P4, P5 and the inclined areas T1, T2, T3, T4 of the buffer layer 120, the active material layer 130m is formed with a thin thickness in the inclined areas T1, T2, T3, T4 due to the taper angle of the buffer layer 120 (see FIG. 6c). On the other hand, the flat areas P1, P2, P3, P4, P5 are flat with respect to the base substrate 110, so that the active material layer 130m is formed with a thicker thickness in the flat areas P1, P2, P3, P4, P5 compared to the inclined areas T1, T2, T3, T4.

For example, the thickness of the active material layer 130m in the inclined areas T1, T2, T3, T4 may be 10% to 60% of the thickness of the active material layer 130m in the flat areas P1, P2, P3, P4, P5 compared to the thickness of the active material layer 130m in the flat areas P1, P2, P3, P4, P5.

For example, when the thickness of the active material layer 130m is 30 nm in the flat areas P1, P2, P3, P4, P5, the thickness of the active material layer 130m in the inclined areas T1, T2, T3, T4 may be 3 nm to 18 nm. In this example, the thickness of the active material layer 130m is measured in a direction perpendicular to the surface of the buffer layer 120.

Thereafter, when annealing treatment is performed on the active material layer 130m, the active material layer 130m formed in the flat areas P1, P2, P3, P4, P5 may have a thickness sufficient for crystallization to proceed and thus may have a crystalline structure.

On the other hand, the active material layer 130m formed in the inclined area T1, T2, T3, T4 does not have a sufficient thickness for crystallization to proceed, and thus may have an amorphous structure, or may have both a crystalline structure and an amorphous structure at the same time.

According to one example of the present disclosure, in a cross-section of a certain layer, when the total area of regions having a grain size of 1 nm or more accounts for 50% or more of the entire cross-sectional area, the layer is referred to as a layer having a crystalline structure. For example, in the active material layer 130m formed in the first flat area P1, the total area of regions having a grain size of 1 nm or more may account for 50% or more of the entire cross-sectional area, and preferably 80% or more. In another example, in the active material layer 130m formed in the first inclined area T1, the total area of regions having a grain size of 1 nm or more may account for less than 50% of the entire cross-sectional area. Specifically, the grain size is measured based on a transmission electron microscope (TEM) image of the cross-section of the layer to be measured.

Thereafter, when wet etching is performed on the active material layer 130m, the active material layer 130m having an amorphous structure can be removed. However, the active material layer 130m not having an amorphous structure has strong resistance to wet etching and may not be removed.

At this time, if the active material layer 130m having an amorphous structure is completely removed, a plurality of active layers 130 may not be disposed on the inclined surface SS as shown in FIG. 4. However, if the active material layer 130m having an amorphous structure is not completely removed by wet etching, or if the active material layer 130m having both a crystalline structure and an amorphous structure is removed by wet etching, a plurality of active layers 130 may partially remain at the end of the inclined surface SS.

Due to this, a plurality of active layers 130 having a crystalline structure can be formed in a spaced apart in the flat areas P1, P2, P3, P4, P5 of the buffer layer 120.

If the thickness of the active material layer 130m is excessively high in the slope area T1, T2, T3, T4, crystallization may occur in the slope area T1, T2, T3, T4 during annealing treatment, and even if wet etching is performed, it may not be removed by wet etching.

In addition, if the thickness of the active material layer 130m is excessively low in the inclined areas T1, T2, T3, T4, the thickness of the active material layer 130m in the flat areas P1, P2, P3, P4, P5 also becomes low, so that crystallization may not proceed during annealing treatment.

According to one example of the present disclosure, the inclined surface SS of the buffer layer 120 may have a taper angle of 45 to 90°.

When the taper angle of the inclined surface SS is less than 45°, the difference between the thickness of the active material layer 130m in the flat areas P1, P2, P3, P4, P5 and the thickness of the active material layer 130m in the inclined areas T1, T2, T3, T4 decreases, so it may be difficult to completely separate the multiple active layers 130.

In addition, when the taper angle of the inclined surface SS exceeds 90°, it may be difficult to actually implement the taper angle of the inclined surface SS to be 90° or more.

Therefore, in order to separate multiple active layers 130, the inclined surface SS of the buffer layer 120 needs to have a taper angle of 45 to 90°.

According to one example of the present disclosure, a plurality of active layers 130 may have a spacing of 0.5 µm or less in a plane.

Referring to FIG. 4, a plurality of active layers 130 may have a spacing W of 0.5 µm or less.

In FIG. 2 and FIG. 4, the second active layer 132 and the third active layer 133 of the plurality of active layers 130 can have a spacing W of 0.5 µm or less.

According to one example of the present disclosure, the plurality of active layers 130 may comprise lower active layers 132, 134 disposed on a first flat surface TS1, and upper active layers 131, 133, 135 disposed on a second flat surface TS2. For example, the lower active layers 132, 134 may comprise a second active layer 132 and a fourth active layer 134, and the upper active layers 131, 133, 135 may comprise a first active layer 131, a third active layer 133, and a fifth active layer 135.

According to one example of the present disclosure, the shortest distance between the upper surface of the lower active layer 132, 134 and the base substrate 110 may be shorter than the shortest distance between the upper surface of the upper active layer 131, 133, 135 and the base substrate 110. For example, FIG. 2 illustrates that the lower active layer 132, 134 is positioned closer to the base substrate 110 compared to the upper active layer 131, 133, 135.

Referring to FIGS. 2 and 4, the lower active layers (such as the second active layer 132and the fourth active layer 134) are disposed on the first flat surface TS1, and the upper active layers ( such as the first active layer 131, the third active layer 133, and the fifth active layer 135) are disposed on the second flat surface TS2. For example, the lower active layers are disposed on the second flat area P2 and the fourth flat area P4, and the upper active layers are disposed on the first flat area P1, the third flat area P3, and the fifth flat area P5.

According to one example of the present disclosure, the lower active layers and the upper active layers may be disposed alternately along the first direction X. For example, FIG. 2 illustrates an example in which the lower active layers and the upper active layers are disposed alternately. For example, the first active layer 131, the second active layer 132, the third active layer 133, the fourth active layer 134, and the fifth active layer 135 may be disposed sequentially along the first direction X.

According to one example of the present disclosure, the buffer layer 120 may comprise a trench 126. According to one example of the present disclosure, the trench 126 may mean an etched region of the buffer layer 120.

Referring to FIGS. 2 and 4, inclined surfaces SS may be disposed on both sides of a trench 126, and a first flat surface TS1 may be disposed between the inclined surfaces SS disposed on both sides.

According to one example of the present disclosure, a gate insulating film 140 is disposed on a plurality of active layers 130. Specifically, the gate insulating film 140 is disposed between the plurality of active layers 130 and a gate electrode 150.

According to one example of the present disclosure, the gate insulating film 140 can cover the entire upper surface of the plurality of active layers 130. FIG. 2 and FIG. 3 illustrate that the gate insulating film 140 covers the entire upper surface of the plurality of active layers 130. However, the examples of the present disclosure are not limited thereto, and the gate insulating film 140 can expose a portion of the plurality of active layers 130.

The gate insulating film 140 may comprise at least one of silicon oxide, silicon nitride, and metal oxide. The gate insulating film 140 may have a single film structure or a multilayer film structure. The gate insulating film 140 protects a plurality of active layers 130.

According to one example of the present disclosure, the plurality of active layers 130 are disposed between the buffer layer 120 and the gate insulating film 140 in the flat areas P1, P2, P3, P4, P5. For example, the plurality of active layers 130 are disposed between the buffer layer 120 and the gate insulating film 140 in the region overlapping the flat areas P1, P2, P3, P4, P5. For example, referring to FIG. 2, the third active layer 133 may be disposed between the buffer layer 120 and the gate insulating film 140 in the region overlapping the third flat area P3.

According to one example of the present disclosure, the gate insulating film 140 may be in contact with the buffer layer 120 in the inclined areas T1, T2, T3, T4. For example, the gate insulating film 140 may be in contact with the buffer layer 120 in the region overlapping the inclined areas T1, T2, T3, T4. For example, referring to FIG. 2, the gate insulating film 140 may be in contact with the buffer layer 120 in the region overlapping the second inclined area T2.

According to one example of the present disclosure, a gate electrode 150 may be disposed on a gate insulating film 140.

Referring to FIGS. 1, 2, and 3, the gate electrode 150 may overlap at least a portion of each of the plurality of active layers 130. For example, referring to FIG. 1, the gate electrode 150 may overlap a portion of each of the first active layer 131, the second active layer 132, the third active layer 133, the fourth active layer 134, the fifth active layer 135, and the sixth active layer 136. The plurality of active layers 130 may each have a channel region overlapping the gate electrode 150.

The gate electrode 150 may comprise at least one of an aluminum series metal such as aluminum (Al) or an aluminum alloy, a silver series metal such as silver (Ag) or a silver alloy, a copper series metal such as copper (Cu) or a copper alloy, a molybdenum series metal such as molybdenum (Mo) or a molybdenum alloy, chromium (Cr), tantalum (Ta), neodymium (Nd), and titanium (Ti). The gate electrode 150 may also have a multilayer film structure including at least two conductive films having different physical properties.

According to one example of the present disclosure, the gate electrode 150 can extend along the first direction X across the plurality of active layers 130.

FIG. 1 illustrates a gate electrode 150 extending along a first direction X across a first active layer 131, a second active layer 132, a third active layer 133, a fourth active layer 134, a fifth active layer 135, and a sixth active layer 136. For example, the gate electrode 150 may be disposed on flat areas P1, P2, P3, P4, P5 and inclined areas T1, T2, T3, T4 of the buffer layer 120.

An interlayer insulating film 160 is disposed on the gate electrode 150. The interlayer insulating film 160 is an insulating layer made of an insulating material. Specifically, the interlayer insulating film 160 may be made of an organic material, an inorganic material, or a laminate of an organic material layer and an inorganic material layer.

A source electrode 171 and a drain electrode 172 are disposed on an interlayer insulating film 160. The source electrode 171 and the drain electrode 172 are spaced apart from each other and are each connected to a plurality of active layers 130. The source electrode 171 and the drain electrode 172 are each connected to a plurality of active layers 130 through contact holes formed in the interlayer insulating film 160. According to one example of the present disclosure, the source electrode 171 may be formed integrally. The drain electrode 172 may be formed integrally. According to one example of the present disclosure, the source electrode 171 may be formed integrally, and the drain electrode 172 may be formed integrally.

The source electrode 171 and the drain electrode 172 may each comprise at least one of molybdenum (Mo), aluminum (Al), chromium (Cr), gold (Au), titanium (Ti), nickel (Ni), neodymium (Nd), copper (Cu), and alloys thereof. The source electrode 171 and the drain electrode 172 may each be formed of a single layer made of a metal or an alloy of metals, or may be formed of multilayers having two or more layers.

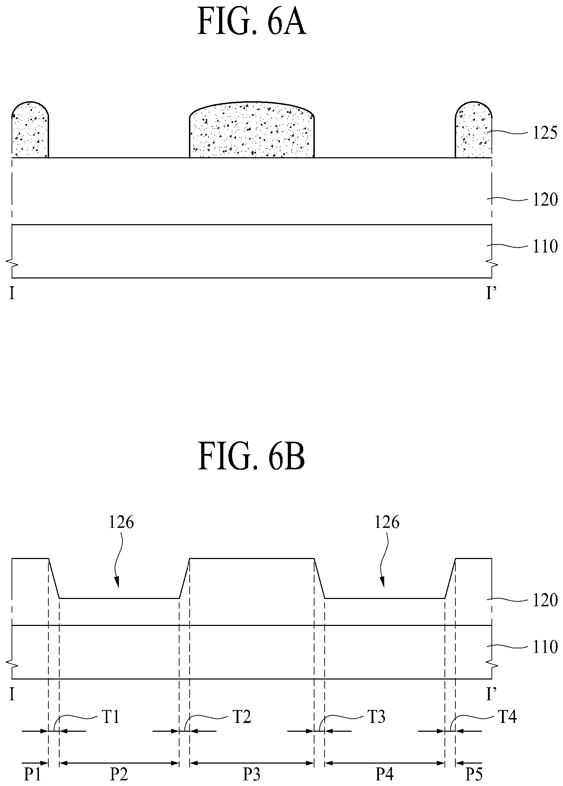

FIGs. 6A to 6H are manufacturing process diagrams of a thin film transistor substrate 100 according to another example of the present disclosure. The details of the configuration already described above are omitted.

The cross-sectional views shown in FIGS. 6A to 6H correspond to the cross-sectional views shown in FIG. 2.

Referring to FIG. 6A, a buffer layer 120 may be formed on a base substrate 110, and a photoresist pattern 125 may be formed on the buffer layer 120. For example, the photoresist pattern 125 is disposed to overlap a portion of the buffer layer 120.

Referring to FIG. 6B, a photoresist pattern 125 may be used as a mask to etch a buffer layer 120 to form a trench 126. Specifically, the buffer layer 120 may be etched to form flat areas P1, P2, P3, P4, P5 and inclined areas T1, T2, T3, T4 that are alternately disposed. More specifically, after etching the buffer layer 120, the photoresist pattern 125 disposed on the buffer layer 120 may be removed.

According to one example of the present disclosure, the buffer layer 120 may have a taper angle of 45 to 90° in the inclined areas T1, T2, T3, T4.

Referring to FIG. 6C, an active material layer 130m may be formed on the buffer layer 120. The active material layer 130m may comprise an oxide semiconductor material. The oxide semiconductor material may comprise, for example, at least one of an IZO (InZnO)-based oxide semiconductor material, an IGO (InGaO)-based oxide semiconductor material, an ITO (InSnO)-based oxide semiconductor material, an IGZO (InGaZnO)-based oxide semiconductor material, an IGZTO (InGaZnSnO)-based oxide semiconductor material, a GZTO (GaZnSnO)-based oxide semiconductor material, a GZO (GaZnO)-based oxide semiconductor material, an ITZO (InSnZnO)-based oxide semiconductor material, and a FIZO (FeInZnO)-based oxide semiconductor material. However, the examples of the present disclosure are not limited thereto, and the active material layer 130m may be formed of other oxide semiconductor materials known in the art.

According to one example of the present disclosure, the thickness L2 of the active material layer 130m disposed in the inclined areas T1, T2, T3, T4 may be 10% to 60% of the thickness L1 of the active material layer 130m disposed in the flat areas P1, P2, P3, P4, P5 compared to the thickness L1. The thickness of the active material layer 130m is measured in a direction perpendicular to the surface of the buffer layer 120.

Referring to FIG. 6D, the active material layer 130m can be annealed. When annealing is performed on the active material layer 130m, the active material layer 130m formed in the flat areas P1, P2, P3, P4, P5 has a thickness sufficient for crystallization to proceed and thus can have a crystalline structure. On the other hand, the active material layer 130m formed in the inclined areas T1, T2, T3, T4 does not have a thickness sufficient for crystallization to proceed and thus can have an amorphous structure, and can have both a crystalline structure and an amorphous structure at the same time.

For example, the annealing treatment step may be performed at a temperature of 350° C. to 450° C. However, one example of the present disclosure is not limited thereto, and the temperature may be different from 350° C. to 450° C.

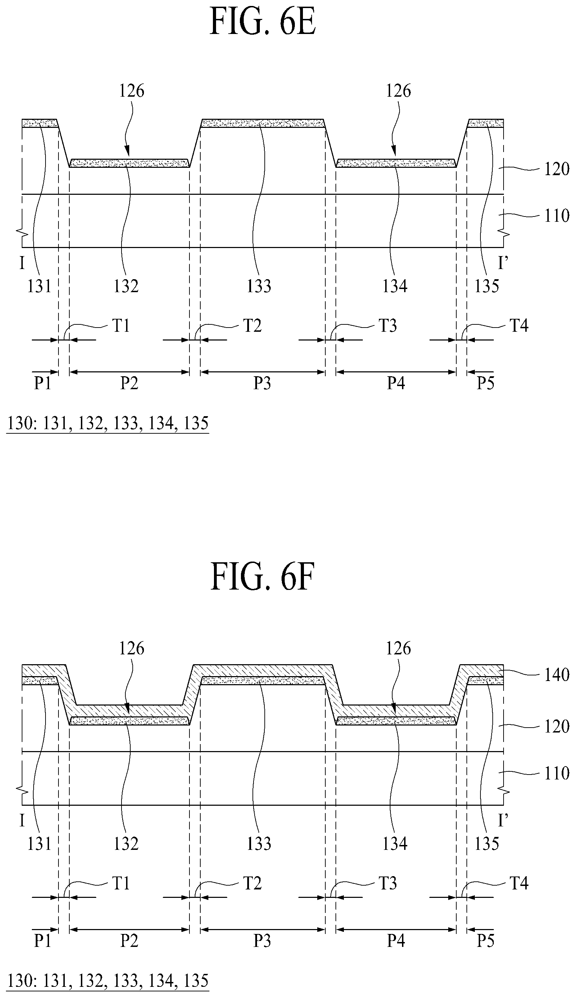

Referring to FIG. 6E, a portion of the active material layer 130m can be removed through wet etching.

For example, an active material layer 130m that is positioned in a slope area T1, T2, T3, T4 and has not undergone crystallization can be selectively removed through wet etching.

According to one example of the present disclosure, a plurality of active layers 130 spaced apart from each other can be formed through wet etching. For example, a first active layer 131, a second active layer 132, a third active layer 133, a fourth active layer 134, and a fifth active layer 135 spaced apart from each other can be formed.

According to one example of the present disclosure, a separate mask is not required in the process of performing wet etching. Specifically, even if wet etching is performed on the entire active material layer 130m, the active material layer 130m having a crystalline structure may not be selectively removed because it has strong resistance to the etchant.

Referring to FIG. 6F, a gate insulating film 140 can be formed on a buffer layer 120 and a plurality of active layers 130. The description of the gate insulating film 140 is omitted as it overlaps with the previous content.

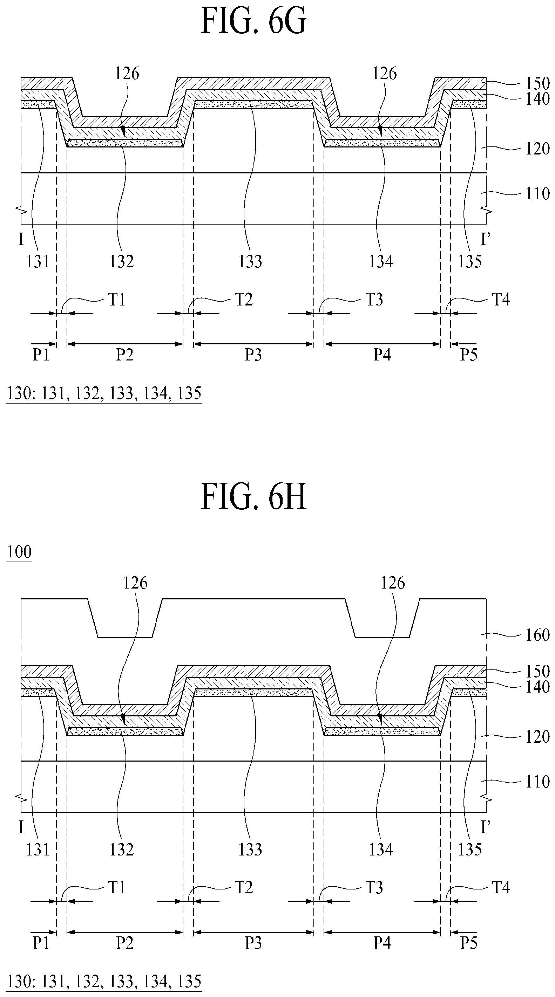

Referring to FIG. 6G, a gate electrode 150 can be formed on a gate insulating film 140. The description of the gate electrode 150 is omitted as it overlaps with the previous content.

Referring to FIG. 6H, an interlayer insulating film 160 can be formed on the gate electrode 150. The description of the interlayer insulating film 160 is omitted as it overlaps with the previous content.

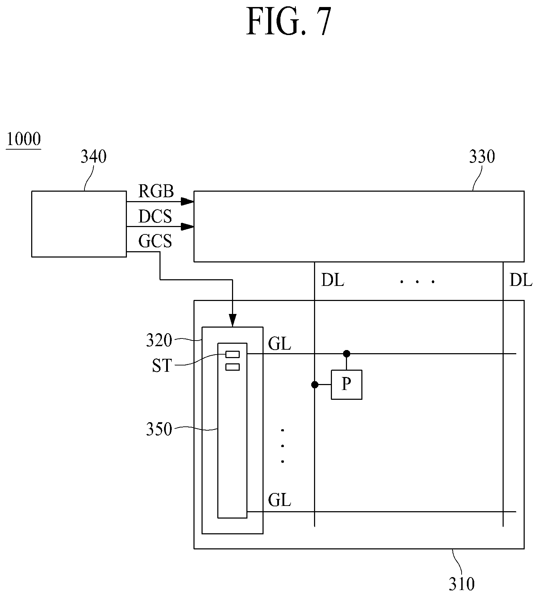

FIG. 7 is a schematic diagram illustrating a display apparatus 1000 according to further still another example of the present disclosure.

As shown in FIG. 7, the display apparatus 1000 according to further still another example of the present disclosure may comprise a display panel 310, a gate driver 320, a data driver 330 and a controller 340.

The display panel 310 comprises gate lines GL and data lines DL, and pixels P are disposed in intersection areas of the gate lines GL and the data lines DL. An image is displayed by driving of the pixels P. The gate lines GL, the data lines DL and the pixels P may be disposed on the base substrate 110.

The controller 340 controls the gate driver 320 and the data driver 330.

The controller 340 outputs a gate control signal GCS for controlling the gate driver 320 and a data control signal DCS for controlling the data driver 330 by using a signal supplied from an external system not shown. Also, the controller 340 samples input image data input from the external system, realigns the sampled data and supplies the realigned digital image data RGB to the data driver 330.

The gate control signal GCS comprises a gate start pulse GSP, a gate shift clock GSC, a gate output enable signal GOE, a start signal Vst and a gate clock GCLK. The gate control signal GCS may also comprise control signals for controlling a shift register.

The data control signal DCS comprises a source start pulse SSP, a source shift clock signal SSC, a source output enable signal SOE and a polarity control signal POL.

The data driver 330 supplies a data voltage to the data lines DL of the display panel 310. In detail, the data driver 330 converts the image data RGB input from the controller 340 into an analog data voltage and supplies the data voltage to the data lines DL.

According to one example of the present disclosure, the gate driver 320 may be packaged on the display panel 310. In this way, a structure in which the gate driver 320 is directly packaged on the display panel 310 will be referred to as a Gate In Panel (GIP) structure. In detail, in the Gate In Panel (GIP) structure, the gate driver 320 may be disposed on the base substrate 110.

The display apparatus 1000 according to one example of the present disclosure may comprise the above-described thin film transistors substrate 100. According to one example of the present disclosure, the gate driver 320 may comprise the above-described thin film transistors substrate 100.

The gate driver 320 may comprise a shift register 350.

The shift register 350 sequentially supplies gate pulses to the gate lines GL for one frame by using the start signal and the gate clock, which are transmitted from the controller 340. In this case, one frame means a time period at which one image is output through the display panel 310. The gate pulse has a turn-on voltage capable of turning on a switching device (thin film transistor) disposed in the pixel P.

Also, the shift register 350 supplies a gate-off signal capable of turning off the switching device, to the gate line GL for the other period of one frame, at which the gate pulse is not supplied. Hereinafter, the gate pulse and the gate-off signal will be collectively referred to as a scan signal SS or Scan.

The shift register 350 may comprise the thin film transistor substrate 100 described above.

Referring to FIG. 7, the shift register 350 according to one example of the present disclosure may comprise a plurality of stages ST.

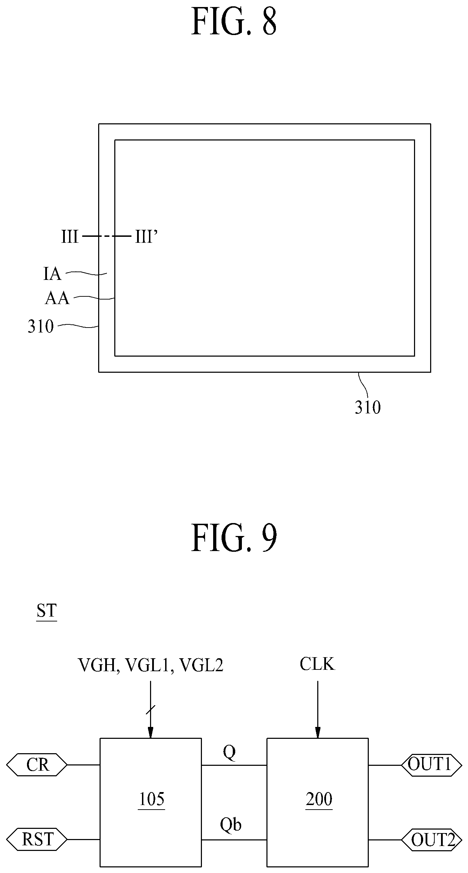

FIG. 8 is a schematic diagram of a display panel 310 according to one example of the present disclosure.

The display panel 310 may comprise a display area AA and a non-display area IA.

A plurality of pixels P for displaying an image may be disposed in the display area AA. In the non-display area IA, no image may be displayed. The non-display area IA may be configured to surround the display area AA. The gate driver 320 may be disposed in the non-display area IA.

The display panel may comprise a first thin film transistor (T3). The first thin film transistor (T3) may be disposed in the non-display area (IA). The first thin film transistor (T3) may comprise a first active layer (A3) having a plurality of sub-active layers (A31, A32, A33, A34, A35, A36, A37) spaced apart from each other. The first thin film transistor (T3) may comprise a first gate electrode (G3) overlapping at least a portion of the first active layer (A3). The display panel may comprise a second thin film transistor (T4) disposed in the non-display area (IA). The second thin film transistor may comprise a buffer layer (112) disposed on a base substrate (110), a second active layer (A4) disposed on the buffer layer (112), and a second gate electrode(G4) overlapping at least a portion of the second active layer (A4). The buffer layer (112) may comprise a plurality of flat areas and a plurality of inclined areas alternately disposed. The plurality of sub-active layers may be spaced apart from each other and disposed in the plurality of flat areas.

FIG. 9 is a block diagram schematically illustrating a stage ST according to one example of the present disclosure.

Referring to FIG. 9, the stage ST comprises a node controller 105. The node controller 105 is configured to control the voltages of first and second nodes Q and Qb. The node controller 105 is configured to control the voltages of first and second nodes Q and Qb in response to a carry signal CR and a reset signal RST. The stage ST comprises an output unit 200. The output unit 200 is configured to output an input clock signal CLK as a scan pulse and an auxiliary scan pulse according to the voltage levels of the first and second nodes Q and Qb. In this case, the scan pulse is output through a first output terminal OUT1 of the stage ST, and the auxiliary scan pulse is output through a second output terminal OUT2 of the stage ST.

The stage ST may receive a gate-on voltage VGH. The stage ST may receive a first gate-off voltage VGL1. The stage ST may receive a second gate-off voltage VGL2.

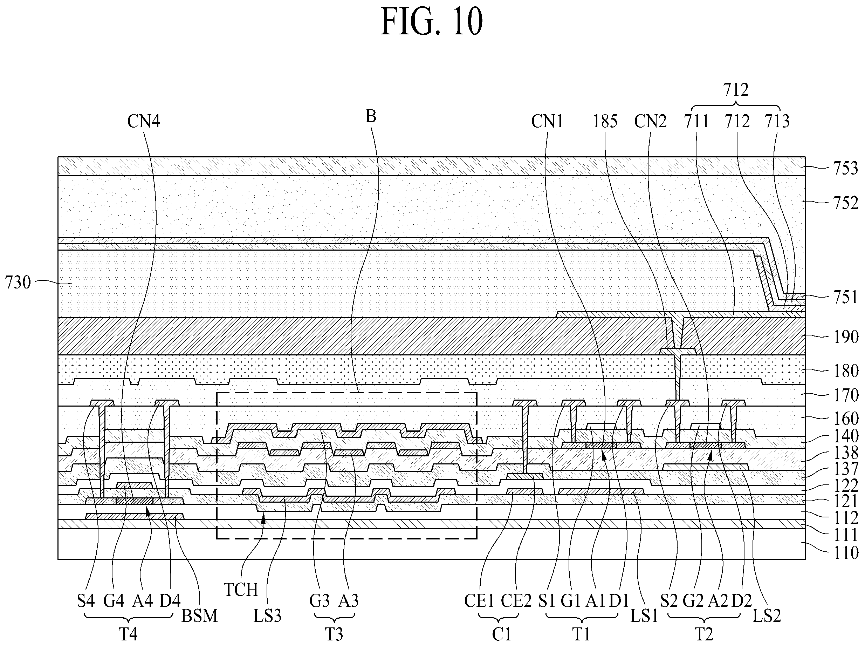

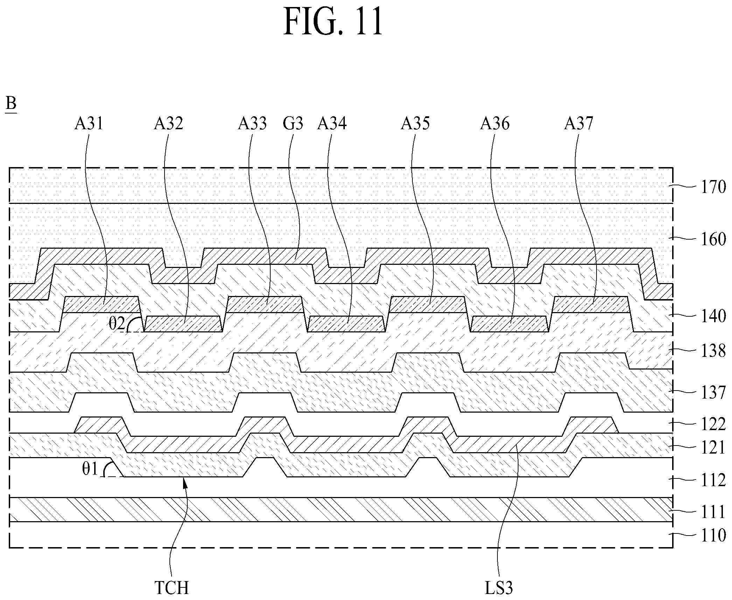

FIG. 10 is a cross-sectional view taken along line III-III' of FIG. 8. FIG. 11 is an enlarged view of area B of FIG. 10.

Referring to FIG. 10, a first thin film transistor T1, a second thin film transistor T2,are disposed in the display area AA. A display element 710 may be disposed in the display area AA. A third thin film transistor T3 and a fourth thin film transistor T4 are disposed in the non-display area IA. The first thin film transistor T1 may be disposed on the base substrate 110. The second thin film transistor T2 may be disposed on the base substrate 110. The third thin film transistor T3 may be disposed on the base substrate 110. The fourth thin film transistor T4 may be disposed on the base substrate 110.

Specifically, the gate driver 320 disposed in the non-display area IA may comprise the third thin film transistor T3 and the fourth thin film transistor T4.

The description of the base substrate 110 is omitted as it overlaps with the previous description.

A first buffer layer 111 and a second buffer layer 112 may be disposed on the base substrate 110.

The first buffer layer 111 and the second buffer layer 112 are each made of an insulating material. Thus, advantageously, the first buffer layer 111 and the second buffer layer 112 protect active layers A1, A2, A3, and A4 of thin film transistors T1, T2, T3, and T4 from moisture, oxygen, and the like introduced from the outside. The second buffer layer 112 may extend from the non-display area IA to the display area AA.

According to one example of the present disclosure, the second buffer layer 112 may comprise a trench TCH. The trench TCH may have a first taper angle θ1. The first taper angle θ1 of the trench TCH may be smaller than a second taper angle θ2 of a second intermediate buffer layer 138, which will be described below. In one or more examples, the first taper angle θ1 of the trench TCH may be smaller than a second taper angle θ2 of a second intermediate buffer layer 138 by 5 degrees. In one or more examples, the first taper angle θ1 of the trench TCH may be smaller than a second taper angle θ2 of a second intermediate buffer layer 138 by 0 to 10 degrees. In one or more examples, the first taper angle θ1 of the trench TCH may be smaller than a second taper angle θ2 of a second intermediate buffer layer 138 by 10 to 20 degrees. A plurality of trenches TCH may be provided.

According to one example of the present disclosure, the trench TCH of the second buffer layer 112 may overlap the third thin film transistor T3. The trench TCH of the second buffer layer 112 may not be disposed in the display area AA. In addition, the trench TCH of the second buffer layer 112 may not overlap the fourth thin film transistor T4. Specifically, the trench TCH of the second buffer layer 112 may not overlap the fourth active layer A4 of the fourth thin film transistor T4. According to one example of the present disclosure, at least a portion of the trench (TCH) of the second buffer layer (112) may overlap the third active layer (A3) of the third thin film transistor (T3).

According to one example of the present disclosure, the second buffer layer 112 may correspond to the buffer layer 120 illustrated in FIG. 1. Therefore, a detailed description of the second buffer layer 112 will be omitted.

A fourth active layer A4 of the fourth thin film transistor T4 is disposed on the second buffer layer 112. The fourth active layer A4 may include a fourth channel region CN4 overlapping the fourth gate electrode G4 of the fourth thin film transistor T4.

A bottom shield metal BSM may be disposed under the fourth thin film transistor T4. The bottom shield metal BSM may be disposed on the first buffer layer 111.

A first lower interlayer insulating film 121 is disposed on the second buffer layer 112. The first lower interlayer insulating film 121 has insulating properties.

Referring to FIG. 10, a first capacitor electrode CE1, a first light-shielding layer LS1, a third light-shielding layer LS3, and a fourth gate electrode G4 may be disposed on the first lower interlayer insulating film 121. The first capacitor electrode CE1, the first light-shielding layer LS1, the third light-shielding layer LS3, and the fourth gate electrode G4 may be disposed on the same layer and may be made of the same material.

A second lower interlayer insulating film 122 is disposed on the first capacitor electrode CE1, the first light-shielding layer LS1, the third light-shielding layer LS3, and the fourth gate electrode G4. A second capacitor electrode CE2 may be disposed on the second lower interlayer insulating film 122. The first capacitor electrode CE1 and the second capacitor electrode CE2 overlap to form a first capacitor C1.

According to one example of the present disclosure, the fourth gate electrode G4 of the fourth thin film transistor T4 may be formed integrally with the third light-shielding layer LS3 of the third thin film transistor T3.

A first intermediate buffer layer 137 is disposed on the second capacitor electrode CE2. A second light-shielding layer LS2 may be disposed on the first intermediate buffer layer 137.

Referring to FIG. 10, a second intermediate buffer layer 138 may be disposed on the second light-shielding layer LS2.

An active layer A1, A2, and A3 is disposed on the second intermediate buffer layer 138. The active layers A1, A2, and A3 may include a first active layer A1 of the first thin film transistor T1, a second active layer A2 of the second thin film transistor T2, and a third active layer A3 of the third thin film transistor T3.

The active layers A1, A2, and A3 may comprise, for example, an oxide semiconductor material. The active layers A1, A2, and A3 may be oxide semiconductor layers formed of an oxide semiconductor material. Specifically, the third active layer A3 may have a crystalline structure.

According to one example of the present disclosure, after the third active layer A3 is formed of an amorphous oxide semiconductor material, the third active layer A3 may be crystallized by annealing treatment, and a crystalline-structured third active layer A3 may be formed through wet etching.

The fourth active layer A4 may comprise a low-temperature polycrystalline silicon (LTPS) semiconductor material. However, the present disclosure is not limited thereto.

The active layers A1, A2, and A4 may each have channel regions CN1, CN2, and CN4, respectively.

Referring to FIGS. 10 and 11, the third active layer A3 may comprise a plurality of sub-active layers A31, A32, A33, A34, A35, A36, and A37. The third active layer A3 illustrated in FIGS. 10 and 11 corresponds to the active layer 130 illustrated in FIG. 1, and the plurality of sub-active layers A31, A32, A33, A34, A35, and A36 correspond to the plurality of active layers 131, 132, 133, 134, 135, and 136 illustrated in FIG. 1.

A gate insulating film 140 is disposed on the active layers A1, A2, and A3. The gate insulating film 140 has insulating properties and separates the active layers A1, A2, and A3 from gate electrodes G1, G2, and G3. The gate insulating film 140 may cover the entire upper surfaces of the active layers A1, A2, and A3.

Gate electrodes G1, G2, and G3 are disposed on the gate insulating film 140. An interlayer insulating film 160 is disposed on the gate electrodes G1, G2, and G3.

Source electrodes S1, S2, and S4 and drain electrodes D1, D2, and D4 are disposed on the interlayer insulating film 160.

The first gate electrode G1 may be connected to the first light-shielding layer LS1 through a connection electrode. As a result, the same voltage as that of the first gate electrode G1 may be applied to the first light-shielding layer LS1. Therefore, the first thin film transistor T1 illustrated in FIG. 10 may be said to have a double-gate structure.

The first thin film transistor T1 may comprise the first active layer A1, the first gate electrode G1, the first source electrode S1, and the first drain electrode D1. The first thin film transistor T1 may serve as a switching transistor that controls a data voltage Vdata applied to a pixel driving unit.

The second thin film transistor T2 may comprise the second active layer A2, the second gate electrode G2, the second source electrode S2, and the second drain electrode D2. The second thin film transistor T2 functions as a driving transistor that controls a driving voltage applied to the display element 710.

A passivation layer 170 is disposed on the source electrodes S1, S2, S4 and the drain electrodes D1, D2, D4. A first planarization layer 180 is disposed on the passivation layer 170. The first planarization layer 180 planarizes the upper portions of the first thin film transistor T1, the second thin film transistor T2, the third thin film transistor T3, and the fourth thin film transistor T4.

A connection electrode 185 may be disposed on the first planarization layer 180. The connection electrode 185 may serve to connect the second source electrode S2 with a pixel electrode 711.

A second planarization layer 190 is disposed on the first planarization layer 180 and the connection electrode 185. The second planarization layer 190 planarizes the upper surface of the pixel driving unit.

A pixel electrode 711 of the display element 710 is disposed on the second planarization layer 190. A bank layer 730 is disposed at the edge of the pixel electrode 711. The bank layer 730 defines an emission area of the display element 710.

An organic light-emitting layer 712 is disposed on the pixel electrode 711, and a common electrode 713 is disposed on the organic light-emitting layer 712.

The common electrode 713 is disposed on the organic light-emitting layer 712, and may also be disposed on the bank layer 730.

The pixel electrode 711, the organic light-emitting layer 712, and the common electrode 713 form the display element 710. The display element 710 illustrated in FIG. 10 is an organic light-emitting diode (OLED). Therefore, the display device 1000 according to one example of the present disclosure is an organic light-emitting display device.

A capping layer may be disposed on the common electrode 713. The capping layer protects the display element 710 and may have insulating properties.

Referring to FIG. 10, a first encapsulation layer 751 is disposed on the common electrode 713. The first encapsulation layer 751 may protect the upper portion of the display element 710.

A second encapsulation layer 752 is disposed on the first encapsulation layer 751. The second encapsulation layer 752 may also be referred to as a particle cover layer (PCL). The second encapsulation layer 752 prevents irregularities from occurring on the surface of the display device 1000 due to particles generated during the manufacturing process of the display device 1000.

A third encapsulation layer 753 may be disposed on the second encapsulation layer 752. The third encapsulation layer 753 may be formed of an inorganic film having a dense thin-film structure. The third encapsulation layer 753 prevents or suppresses penetration of moisture or oxygen.

According to one example of the present disclosure, the first encapsulation layer 751, the second encapsulation layer 752, and the third encapsulation layer 753 may collectively be referred to as an encapsulation part.

According to the present disclosure, the following advantageous effects may be obtained.

A thin film transistor substrate according to one example of the present disclosure can separate the active layers from each other by disposing a layer having a step below the active layer.

A thin film transistor substrate according to another example of the present disclosure can minimize the gap between active layers.

A display device according to another example of the present disclosure may have a bezel area with a reduced area.

In addition to the effects mentioned above, other features and advantages of the present disclosure are described below or may be clearly understood by those skilled in the art to which the present disclosure pertains from such description and explanation.

It will be apparent to those skilled in the art that the present disclosure described above is not limited by the above-described examples and the accompanying drawings and that various substitutions, modifications and variations can be made in the present disclosure without departing from the scope of the disclosure. Consequently, the scope of the present disclosure is defined by the accompanying claims and it is intended that all variations or modifications derived from the meaning, scope and equivalent concept of the claims fall within the scope of the present disclosure.

Described herein is a thin film transistor substrate (100), the thin film transistor substrate (100) comprising: a buffer layer (120) disposed on a base substrate (110) and a plurality of thin film transistors (TR1, TR2, TR3, TR4, TR5, TR6) on the buffer layer (120), wherein the plurality of thin film transistors (TR1, TR2, TR3, TR4, TR5, TR6) comprise a plurality of active layers (130, 131, 132, 133, 134, 135, 136) and a gate electrode (150) overlapping at least a portion of each of the plurality of active layers (130, 131, 132, 133, 134, 135, 136), wherein the buffer layer (120) comprises a plurality of flat areas (P1, P2, P3, P4, P5) and a plurality of inclined areas (T1, T2, T3, T4) alternately disposed with each other, and wherein the plurality of active layers (130, 131, 132, 133, 134, 135, 136) are spaced apart from each other and disposed in the plurality of flat areas (P1, P2, P3, P4, P5).

Described herein is also a display apparatus comprising a thin film transistor substrate described herein.

Described herein is a method of manufacturing a display apparatus comprising a thin film transistor substrate (100), the method comprising steps of: forming a buffer layer (120) on a base substrate (110); forming a photoresist pattern (125) on the buffer layer (120); etching the buffer layer (120) using the photoresist pattern (125) as a mask to form flat areas (P1, P2, P3, P4, P5) and inclined areas (T1, T2, T3, T4) that are alternately disposed; forming an active material layer (130m) on the buffer layer (120); annealing the active material layer (130m); and removing a portion of the active material layer (130m) disposed in the inclined areas (T1, T2, T3, T4) by wet etching; and optionally, wherein the active material layer (130m) disposed on the flat areas (P1, P2, P3, P4, P5) is crystallized by the annealing; and optionally wherein the buffer layer (120) has a taper angle of 45 to 90° in the inclined areas (T1, T2, T3, T4); and optionally wherein a thickness of the active material layer (130m) disposed in the inclined areas (T1, T2, T3, T4) is 10% to 60% compared to a thickness of the active material layer (130m) disposed in the flat areas (P1, P2, P3, P4, P5), and wherein the thickness of the active material layer (130m) is measured in a direction perpendicular to a surface of the buffer layer (120).

Described herein are also the following clauses:
C1. A display apparatus comprising: a display area (AA) and a non-display area (IA) surrounding the display area (AA), a first thin film transistor (T3) disposed in the non-display area (IA), the first thin film transistor (T3) comprising a first active layer (A3) having a plurality of sub-active layers (A31, A32, A33, A34, A35, A36, A37) spaced apart from each other, and a first gate electrode (G3) overlapping at least a portion of the first active layer (A3); and a second thin film transistor (T4) disposed in the non-display area (IA), the second thin film transistor (T4) comprising a buffer layer (112) disposed on a base substrate (110), a second active layer (A4) disposed on the buffer layer (112), and a second gate electrode(G4) overlapping at least a portion of the second active layer (A4), wherein the buffer layer (112) comprises flat areas and inclined areas alternately disposed, and wherein the plurality of sub-active layers (A31, A32, A33, A34, A35, A36, A37) are spaced apart from each other and disposed in the flat areas.
C2. The display apparatus of clause C1, wherein the buffer layer (112) extends from the non-display area (IA) to the display area (AA), wherein the buffer layer (112) comprises a trench (TCH) wherein at least a portion of the trench (TCH) overlaps the first active layer (A3) of the first thin film transistor (T3).
C3. The display apparatus of claim C2, wherein the trench (TCH) is not disposed in the display area (AA).
C4. The display apparatus of any one of the clauses C2 to C3, wherein the trench (TCH) does not overlap a second active layer (A4) of the second thin film transistor (T4).
C5. The display apparatus of any one of the clauses C2 to C4, wherein the first active layer (A3) comprises an oxide semiconductor material, and wherein the second active layer (A4) comprises a low-temperature polycrystalline silicon semiconductor material.
C6. The display apparatus of any one of the clauses C2 to C5, wherein the first thin film transistor (T3) comprises a first light-shielding layer (LS3) overlapping the first active layer (A3), and wherein the first light-shielding layer (LS3) is integrally formed with the second gate electrode (G4).
C7. The display apparatus of clause C6, wherein the first thin film transistor (T3) comprises an intermediate buffer layer (138) disposed below the first active layer (A3),wherein the first active layer (A3) is disposed on an upper surface of the intermediate buffer layer (138), wherein the buffer layer (112) has a first taper angle (θ1), and wherein the intermediate buffer layer (138) has a second taper angle (θ2) greater than the first taper angle (θ1).
C8. The display apparatus of any one of preceding clauses C1 to C7, further comprising a first lower interlayer insulating film (121) and a second lower interlayer insulating film (122); the display apparatus further comprising a first capacitor electrode (CE1) and a first light-shielding layer (LS1) and a third light-shielding layer (LS3) and a fourth gate electrode (G4) disposed on the first lower interlayer insulating film (121); wherein the second lower interlayer insulating film (122) is disposed on the first capacitor electrode (CE1) and the first light-shielding layer (LS1) and the third light-shielding layer (LS3) and the fourth gate electrode (G4); and a second capacitor electrode (CE2) is disposed on the second lower interlayer insulating film (122) so that the first capacitor electrode (CE1) and the second capacitor electrode (CE2) overlap to form a first capacitor (C1).
C9. The display apparatus of clause C8, wherein the fourth gate electrode (G4) is formed integrally with the third light-shielding layer (LS3).
C10. The display apparatus of any one of the clauses C8 to C9, further comprising a first intermediate buffer layer (137) disposed on the second capacitor electrode (CE2); and a second intermediate buffer layer (138) disposed on a second light-shielding layer (LS2); wherein the second light-shielding layer (LS2) is disposed on the first intermediate buffer layer (137).
C11. The display apparatus of any one of the clauses C8 to C9, wherein the display apparatus is an organic light-emitting display device.
C12. A display apparatus of any one of the clauses C1 to C11, wherein the plurality of sub-active layers (A31, A32, A33, A34, A35, A36, A37) are spaced apart from each other by the inclined areas.

The following clauses are also provided herein:
1. A thin film transistor substrate comprising:
   a buffer layer disposed on a base substrate and
   a plurality of thin film transistors on the buffer layer,
   wherein the plurality of thin film transistors include a plurality of active layers and a gate electrode overlapping at least a portion of each of the plurality of active layers,
   wherein the buffer layer includes a flat area and an inclined area alternately disposed with each other, and
   wherein the plurality of active layers are spaced apart from each other and disposed in the flat area.
2. The thin film transistor substrate of clause 1, wherein the plurality of active layers include an oxide semiconductor material and have a crystalline structure.
3. The thin film transistor substrate of clause 1, wherein the plurality of active layers are disposed to be spaced apart from each other in a first direction,
   wherein the flat area and the inclined area are disposed to extend along a second direction perpendicular to the first direction, and
   wherein the flat area and the inclined area are disposed to be parallel along the first direction.
4. The thin film transistor substrate of clause 3, wherein the plurality of active layers are disposed to extend along the second direction.
5. The thin film transistor substrate of clause 1, wherein the buffer layer includes a first flat surface and a second flat surface disposed in the flat area, and an inclined surface disposed in the inclined area, and
   wherein the plurality of active layers are not disposed on the inclined surface.
6. The thin film transistor substrate of clause 1, wherein the buffer layer includes a first flat surface and a second flat surface disposed in the flat area, and an inclined surface disposed in the inclined area, and
   the plurality of active layers include a region remaining at an end of the inclined surface.
7. The thin film transistor substrate of clause 6, wherein the plurality of active layers are disposed in a parallel spaced apart along a first direction,
   wherein the flat area and the inclined area are disposed to extend along a second direction perpendicular to the first direction, respectively, and
   wherein the region remaining at the end of the inclined surface is disposed to extend along the second direction.
8. The thin film transistor substrate of clause 5, wherein the first flat surface, the inclined surface, and the second flat surface extend along the first direction,
   wherein the inclined surface is disposed between the first flat surface and the second flat surface, and
   wherein a shortest distance between the first flat surface and the base substrate is shorter than a shortest distance between the second flat surface and the base substrate.
9. The thin film transistor substrate of clause 5, wherein the inclined surface has a taper angle of 45 to 90°.
10. The thin film transistor substrate of clause 1, wherein the plurality of active layers have a spacing of 0.5 µm or less in a plane.
11. The thin film transistor substrate of clause 6, wherein the plurality of active layers include:
   a lower active layer disposed on the first flat surface; and
   an upper active layer disposed on the second flat surface,
   wherein the lower active layer and the upper active layer are alternately disposed along the first direction, and
   wherein a shortest distance between an upper surface of the lower active layer and the base substrate is shorter than a shortest distance between an upper surface of the upper active layer and the base substrate.
12. The thin film transistor substrate of clause 1, wherein the gate electrode extends in a first direction across the plurality of active layers and be disposed on the flat area and the inclined area.
13. The thin film transistor substrate of clause 1, further includes a gate insulating film disposed on the buffer layer,
   wherein the plurality of active layers are disposed between the buffer layer and the gate insulating film in the flat area, and
   wherein the gate insulating film is in contact with the buffer layer in the inclined area.
14. The thin film transistor substrate of clause 5, wherein the buffer layer includes a trench,
   wherein the inclined surfaces are disposed on both sides of the trench, and
   wherein the first flat surface is disposed between the inclined surfaces.
15. A method for manufacturing a thin film transistor substrate comprising steps of:
   forming a buffer layer on a base substrate;
   forming a photoresist pattern on the buffer layer;
   etching the buffer layer using the photoresist pattern as a mask to form flat area and inclined area that are alternately disposed;
   forming an active material layer on the buffer layer;
   annealing the active material layer; and
   removing a portion of the active material layer disposed in the inclined area by wet etching.
16. The method for manufacturing a thin film transistor substrate of clause 15, wherein the active material layer disposed on the flat area is crystallized by the annealing.
17. The method for manufacturing a thin film transistor substrate of clause 15, wherein the buffer layer has a taper angle of 45 to 90° in the inclined area.
18. The method for manufacturing a thin film transistor substrate of clause 15, wherein a thickness of the active material layer disposed in the inclined area is 10% to 60% compared to a thickness of the active material layer disposed in the flat area, and
   wherein the thickness of the active material layer is measured in a direction perpendicular to a surface of the buffer layer.
19. A display apparatus including a thin film transistor substrate of any one of clauses 1 to 14.
Described herein are also the following clauses.
D1. A display apparatus comprising a thin film transistor substrate, the thin film transistor substrate comprising: a buffer layer disposed on a base substrate and a plurality of thin film transistors on the buffer layer, wherein the plurality of thin film transistors comprise a plurality of active layers and a gate electrode overlapping at least a portion of each of the plurality of active layers, wherein the buffer layer comprises flat areas and inclined areas alternately disposed with each other, and wherein the plurality of active layers are spaced apart from each other and disposed in the flat areas.
D2. The display apparatus of clause D1,wherein the plurality of active layers are spaced apart from each other by inclined areas and disposed in the flat areas.
D3. The display apparatus of clause D1, wherein the plurality of active layers are disposed to be spaced apart from each other in a first direction, wherein the flat areas and the inclined areas are disposed to extend along a second direction perpendicular to the first direction, and wherein the flat areas and the inclined areas are disposed to be parallel along the first direction.
D4. The display apparatus of clause D3, wherein the plurality of active layers are disposed to extend along the second direction.
D5. The display apparatus of clause D1, wherein the flat areas comprise a first flat surface and a second flat surface; and wherein each inclined area of the inclined areas comprises an inclined surface, and wherein the plurality of active layers are not disposed on the inclined surfaces; and optionally wherein the buffer layer comprises a trench, wherein the inclined surface is disposed on both sides of the trench, and wherein the first flat surface is disposed between the inclined surfaces; and optionally wherein each inclined surface has a taper angle of 45 to 90°.
D6. The display apparatus of clause D1, wherein the flat areas comprise a first flat surface and a second flat surface; and wherein each inclined area of the inclined areas comprises an inclined surface, and the plurality of active layers comprises a region positioned at both ends of the inclined surface.
D7. The display apparatus of clause D6, wherein the plurality of active layers are disposed in a parallel spaced apart along a first direction, wherein the flat areas and the inclined areas are disposed to extend along a second direction perpendicular to the first direction, respectively, and wherein the regions are disposed to extend along the second direction.
D8. The display apparatus of clause D5, wherein the first flat surface, the inclined surface, and the second flat surface extend along the first direction, wherein the inclined surface is disposed between the first flat surface and the second flat surface, and wherein a shortest distance between the first flat surface and the base substrate is shorter than a shortest distance between the second flat surface and the base substrate.
D9. The display apparatus of clause D1, wherein the plurality of active layers comprise an oxide semiconductor material and have a crystalline structure; and optionally, wherein the plurality of active layers have a spacing of 0.5 µm or less in a plane.
D10. The display apparatus of clause D6, wherein the plurality of active layers comprise: the first flat surface forming a lower active layer; and the second flat surface forming an upper active layer, wherein the lower active layer and the upper active layer are alternately disposed along the first direction, and wherein a shortest distance between an upper surface of the lower active layer and the base substrate is shorter than a shortest distance between an upper surface of the upper active layer and the base substrate.
D11. The display apparatus of clause D1, wherein the gate electrode extends in a first direction across the plurality of active layers and wherein the gate electrode is disposed on the flat areas and the inclined areas.
D12. The display apparatus of clause D1, further comprises a gate insulating film disposed on the buffer layer, wherein the plurality of active layers are disposed between the buffer layer and the gate insulating film in the flat areas, and wherein the gate insulating film is in contact with the buffer layer in the inclined areas.
D13. The display apparatus of clause D1, further comprising a source electrode and a drain electrode respectively connected to the plurality of active layers and disposed to be spaced apart from each other, and optionally, wherein the source electrode is integrally formed, and the drain electrode is integrally formed.
D14. The display apparatus of clause D1, wherein the plurality of thin film transistors are configured to be driven simultaneously.
D15. A method for manufacturing a thin film transistor substrate for a display apparatus, the method comprising steps of: forming a buffer layer on a base substrate; forming a photoresist pattern on the buffer layer; etching the buffer layer using the photoresist pattern as a mask to form flat areas and inclined areas that are alternately disposed; forming an active material layer on the buffer layer; annealing the active material layer; and removing a portion of the active material layer disposed in the inclined areas by wet etching.
D16. The method of clause D15, wherein the active material layer disposed on the flat areas is crystallized by the annealing; and optionally wherein the buffer layer has a taper angle of 45 to 90° in the inclined areas; and optionally wherein a thickness of the active material layer disposed in the inclined areas is 10% to 60% compared to a thickness of the active material layer disposed in the flat areas, and wherein the thickness of the active material layer is measured in a direction perpendicular to a surface of the buffer layer.
D17. A display apparatus comprising: a display area and a non-display area surrounding the display area, a first thin film transistor disposed in the non-display area, the first thin film transistor comprising a first active layer having a plurality of sub-active layers spaced apart from each other, and a first gate electrode overlapping at least a portion of the first active layer; and a second thin film transistor disposed in the non-display area, the second thin film transistor comprising a buffer layer disposed on a base substrate, a second active layer disposed on the buffer layer, and a second gate electrode overlapping at least a portion of the second active layer, wherein the buffer layer comprises flat areas and inclined areas alternately disposed, andwherein the plurality of sub-active layers are spaced apart from each other by the inclined areas and disposed in the flat areas.
D18. The display apparatus of clause D17, wherein the buffer layer extends from the non-display area to the display area, wherein the buffer layer comprises a trench; wherein at least a portion of the trench overlaps the first active layer of the first thin film transistor.
D19. The display apparatus of clause D17, wherein the first thin film transistor comprises an intermediate buffer layer disposed below the first active layer, wherein the first active layer is disposed on an upper surface of the intermediate buffer layer, wherein the buffer layer has a first taper angle, and wherein the intermediate buffer layer has a second taper angle greater than the first taper angle.
D20. The display apparatus of clause D18, wherein the trench is not disposed in the display area;
   and optionally wherein the trench does not overlap a second active layer of the second thin film transistor; and optionally wherein the second active layer comprises a low-temperature polycrystalline silicon semiconductor material; and optionally wherein the first thin film transistor comprises a first light-shielding layer overlapping the first active layer, and wherein the first light-shielding layer is integrally formed with the second gate electrode.

## Claims

1. A display apparatus comprising a thin film transistor substrate (100), the thin film transistor substrate (100) comprising:
a buffer layer (120) disposed on a base substrate (110) and
a plurality of thin film transistors (TR1, TR2, TR3, TR4, TR5, TR6) on the buffer layer (120),
wherein the plurality of thin film transistors (TR1, TR2, TR3, TR4, TR5, TR6) comprise a plurality of active layers (130, 131, 132, 133, 134, 135, 136) and a gate electrode (150) overlapping at least a portion of each of the plurality of active layers (130, 131, 132, 133, 134, 135, 136),
wherein the buffer layer (120) comprises flat areas (P1, P2, P3, P4, P5) and inclined areas (T1, T2, T3, T4) alternately disposed with each other, and
wherein the plurality of active layers (130, 131, 132, 133, 134, 135, 136) are spaced apart from each other and disposed in the flat areas (P1, P2, P3, P4, P5).

2. The display apparatus of claim 1,
wherein the plurality of active layers (130, 131, 132, 133, 134, 135, 136) are spaced apart from each other by inclined areas (T1, T2, T3, T4) and disposed in the flat areas (P1, P2, P3, P4, P5).

3. The display apparatus of any one of the preceding claims, wherein the plurality of active layers (130, 131, 132, 133, 134, 135, 136) are disposed to be spaced apart from each other in a first direction,
wherein the flat areas (P1, P2, P3, P4, P5) and the inclined areas (T1, T2, T3, T4) are disposed to extend along a second direction perpendicular to the first direction, and
wherein the flat areas (P1, P2, P3, P4, P5) and the inclined areas (T1, T2, T3, T4) are disposed to be parallel along the first direction.

4. The display apparatus of claim 3, wherein the plurality of active layers (130, 131, 132, 133, 134, 135, 136) are disposed to extend along the second direction.

5. The display apparatus of any one of the preceding claims,
wherein the flat areas (P1, P2, P3, P4, P5) comprise a first flat surface (TS1) and a second flat surface (TS2); and
wherein each inclined area of the inclined areas (T1, T2, T3, T4) comprises an inclined surface (SS), and
wherein the plurality of active layers (130, 131, 132, 133, 134, 135, 136) are not disposed on the inclined surfaces (SS);
and optionally wherein the buffer layer (120) comprises a trench (126),
wherein the inclined surface (SS) is disposed on both sides of the trench (126), and
wherein the first flat surface (TS1) is disposed between the inclined surfaces (SS);
and optionally wherein each inclined surface (SS) has a taper angle of 45 to 90°.

6. The display apparatus of any one of the preceding claims,
wherein the flat areas (P1, P2, P3, P4, P5) comprise a first flat surface (TS1) and a second flat surface (TS2); and
wherein each inclined area of the inclined areas (T1, T2, T3, T4) comprises an inclined surface (SS), and
the plurality of active layers (130, 131, 132, 133, 134, 135, 136) comprises a region (a1, a2) positioned at both ends of the inclined surface (SS).

7. The display apparatus of claim 6, wherein the plurality of active layers (130, 131, 132, 133, 134, 135, 136) are disposed in a parallel spaced apart along a first direction,
wherein the flat areas (P1, P2, P3, P4, P5) and the inclined areas (T1, T2, T3, T4) are disposed to extend along a second direction perpendicular to the first direction, respectively, and
wherein the regions (a1, a2) are disposed to extend along the second direction.

8. The display apparatus of claim 5, wherein the first flat surface (TS1), the inclined surface (SS), and the second flat surface (TS2) extend along the first direction,
wherein the inclined surface (SS) is disposed between the first flat surface (TS1) and the second flat surface (TS2), and
wherein a shortest distance between the first flat surface (TS1) and the base substrate (110) is shorter than a shortest distance between the second flat surface (TS2) and the base substrate (110).

9. The display apparatus of any one of the preceding claims,
wherein the plurality of active layers (130, 131, 132, 133, 134, 135, 136) comprise an oxide semiconductor material and have a crystalline structure; and optionally,
wherein the plurality of active layers (130, 131, 132, 133, 134, 135, 136) have a spacing of 0.5 µm or less in a plane.

10. The display apparatus of any one of the claims 6 to 7, wherein the plurality of active layers (130, 131, 132, 133, 134, 135, 136) comprise:
the first flat surface (TS1) forming a lower active layer; and
the second flat (TS2) surface forming an upper active layer,
wherein the lower active layer and the upper active layer are alternately disposed along the first direction, and
wherein a shortest distance between an upper surface of the lower active layer and the base substrate (110) is shorter than a shortest distance between an upper surface of the upper active layer and the base substrate (110).

11. The display apparatus of any one of the preceding claims, wherein the gate electrode (150) extends in a first direction across the plurality of active layers (130, 131, 132, 133, 134, 135, 136) and wherein the gate electrode (150) is disposed on the flat areas (P1, P2, P3, P4, P5) and the inclined areas (T1, T2, T3, T4).

12. The display apparatus of any one of the preceding claims, further comprises a gate insulating film (140) disposed on the buffer layer (120),
wherein the plurality of active layers (130, 131, 132, 133, 134, 135, 136) are disposed between the buffer layer (120) and the gate insulating film (140) in the flat areas (P1, P2, P3, P4, P5), and
wherein the gate insulating film (140) is in contact with the buffer layer (120) in the inclined areas (T1, T2, T3, T4).

13. The display apparatus of any one of the claims 1 to 12, further comprising a source electrode (171) and a drain electrode (172) respectively connected to the plurality of active layers (130, 131, 132, 133, 134, 135, 136) and disposed to be spaced apart from each other,
and optionally, wherein the source electrode (171) is integrally formed, and the drain electrode (172) is integrally formed.

14. The display apparatus of any one of the preceding claims, wherein the plurality of thin film transistors (TR1, TR2, TR3, TR4, TR5, TR6) are configured to be driven simultaneously.

15. A method for manufacturing a thin film transistor substrate (100) for a display apparatus, the method comprising steps of:
forming a buffer layer (120) on a base substrate (110);
forming a photoresist pattern (125) on the buffer layer (120);
etching the buffer layer (120) using the photoresist pattern (125) as a mask to form flat areas (P1, P2, P3, P4, P5) and inclined areas (T1, T2, T3, T4) that are alternately disposed;
forming an active material layer (130m) on the buffer layer (120);
annealing the active material layer (130m); and
removing a portion of the active material layer (130m) disposed in the inclined areas (T1, T2, T3, T4) by wet etching;
and optionally,
wherein the active material layer (130m) disposed on the flat areas (P1, P2, P3, P4, P5) is crystallized by the annealing;
and optionally wherein the buffer layer (120) has a taper angle of 45 to 90° in the inclined areas (T1, T2, T3, T4);
and optionally wherein a thickness of the active material layer (130m) disposed in the inclined areas (T1, T2, T3, T4) is 10% to 60% compared to a thickness of the active material layer (130m) disposed in the flat areas (P1, P2, P3, P4, P5), and
wherein the thickness of the active material layer (130m) is measured in a direction perpendicular to a surface of the buffer layer (120).
